# EUROPÄISCHE PATENTSCHRIFT

(11) **EP 2 463 889 B1**
(45) Veröffentlichungstag und Bekanntmachung des Hinweises auf die Patenterteilung: **15.03.2017**
(21) Anmeldenummer: 12158480.9
(22) Anmeldetag: 07.01.2004
(51) Int. Cl.: H01J 37/28, H01J 37/244

(54) **Elektronenstrahlgerät und Verfahren zum Betrieb dessen**
Electron beam apparatus and method of operating the same
Appareil à faisceau électronique et son procédé de fonctionnement

(30) Priorität: 16.01.2003 DE 10301579
(43) Veröffentlichungstag der Anmeldung: 13.06.2012
(62) Teilanmeldung aus: 04000137.2
(73) Patentinhaber: Carl Zeiss Microscopy GmbH, 07745 Jena (DE)
(72) Erfinder: Steigerwald, Michael, 73463 Westhausen (DE); Preikszas, Dirk, 73447 Oberkochen (DE); Drexel, Volker, 89551 Königsbronn (DE)
(74) Vertreter: Tongbhoyai, Martin

(56) Entgegenhaltungen:
- EP-A1- 0 917 177
- EP-A1- 1 063 677
- WO-A1-99/46797
- DE-A1- 19 828 476
- JP-A- 9 167 591
- JP-A- 10 214 586
- JP-A- 2000 188 077
- US-A- 5 097 126
- US-A- 6 011 262
- US-A- 6 043 491
- MUNACK HARRY ET AL: "Design and implementation of a detector for on-axis electrons for enabling enhanced imaging of topographical structures", JOURNAL OF VACUUM SCIENCE & TECHNOLOGY B: MICROELECTRONICSPROCESSING AND PHENOMENA, AMERICAN VACUUM SOCIETY, NEW YORK, NY, US, Bd. 17, Nr. 6, 1. November 1999 (1999-11-01), Seiten 2827-2829, XP012007827, ISSN: 0734-211X, DOI: 10.1116/1.591075

## Beschreibung

Die Erfindung betrifft ein Elektronenstrahlgerät, insbesondere ein Rasterelektronenmikroskop, mit einem Strahlerzeuger zur Erzeugung eines Elektronenstrahls, einer Objektivlinse zur Fokussierung des Elektronenstrahls auf einem Objekt und mindestens einem Detektor zur Detektion von am Objekt gestreuten oder vom Objekt emittierten Elektronen. Des weiteren betrifft die Erfindung ein Verfahren zum Betrieb eines Elektronenstrahlgeräts.

Elektronenstrahlgeräte, insbesondere Rasterelektronenmikroskope, werden zur Untersuchung von Oberflächen von Objekten (Proben) verwendet. Hierzu wird bei einem Rasterelektronenmikroskop ein Elektronenstrahl (nachfolgend Primärelektronenstrahl genannt) mittels des Strahlerzeugers erzeugt und durch die Objektivlinse auf das zu untersuchende Objekt fokussiert. Mittels einer Ablenkeinrichtung wird der Primärelektronenstrahl rasterförmig über die Oberfläche des zu untersuchenden Objektes geführt. Die Elektronen des Primärelektronenstrahls treten dabei in Wechselwirkung mit dem Objekt. Als Folge der Wechselwirkung werden insbesondere Elektronen aus der Objektoberfläche emittiert (sogenannte Sekundärelektronen) oder Elektronen des Primärelektronenstrahls zurückgestreut (sogenannte Rückstreuelektronen). Die Rückstreuelektronen weisen dabei eine Energie im Bereich von 50 eV bis zur Energie der Elektronen des Primärelektronenstrahls am Objekt auf, während die Sekundärelektronen eine Energie kleiner als 50 eV aufweisen. Sekundär- und Rückstreuelektronen bilden den nachfolgend so genannten Sekundärstrahl und werden mit einem Detektor detektiert. Das hierdurch erzeugte Detektorsignal wird zur Bilderzeugung verwendet.

Elektronenstrahlgeräte weisen eine hohe Ortsauflösung auf, die durch einen sehr geringen Durchmesser des Primärelektronenstrahls in der Ebene des Objektes erzielt wird. Die Auflösung ist um so besser, je näher das Objekt an der Objektivlinse des Elektronenstrahlgerätes angeordnet ist. Zum Nachweis der Sekundär- oder Rückstreuelektronen ist der Detektor hierbei innerhalb der Objektivlinse oder in einem Bereich zwischen der Objektivlinse und dem Strahlerzeuger angeordnet. Ferner wird die Auflösung um so besser, je höher die Elektronen des Primärelektronenstrahls im Elektronenstrahlgerät zunächst beschleunigt und am Ende in der Objektivlinse oder im Bereich zwischen der Objektivlinse und dem Objekt auf eine gewünschte Endenergie abgebremst werden.

Es sind Elektronenstrahlgeräte bekannt, die einen ringförmigen Detektor mit einer relativ großen Öffnung aufweisen. Diese Öffnung ist notwendig, um den Primärelektronenstrahl im Strahlengang des Elektronenstrahlgerätes nicht zu beeinflußen und um mögliche Kontaminationen zu vermeiden. Die rücklaufenden Bahnen der Sekundär- und Rückstreuelektronen im Elektronenstrahlgerät werden durch die Objektivlinse aufgrund der unterschiedlichen Energien der Sekundär- und Rückstreuelektronen beeinflußt. Der Cross-Over des Strahls der Sekundärelektronen liegt dabei näher an dem zu untersuchenden Objekt als der Cross-Over des Strahls der Rückstreuelektronen. Deshalb weist der Strahl der Sekundärelektronen mehr Divergenz als der Strahl der Rückstreuelektronen auf. Allerdings verlaufen die Sekundär- und Rückstreuelektronen auf derartigen Bahnen, daß ein Großteil der Sekundär- und Rückstreuelektronen durch die Öffnung des Detektors hindurchtritt und somit nicht detektiert wird.

In der DE 198 28 476 A1 ist ein Lösungsweg beschrieben, um dem vorstehend genannten Nachteil zu entgehen. Bei dem aus dieser Druckschrift bekannten Elektronenstrahlgerät sind zwei, jeweils eine Öffnung aufweisende Detektoren für die Sekundär- und Rückstreuelektronen entlang der optischen Achse des Elektronenstrahlgerätes zueinander versetzt angeordnet. Der in der Nähe des Objektes angeordnete erste Detektor dient dabei zur Detektion der Elektronen, die unter einem relativ großen Raumwinkel aus dem Objekt austreten, während der im Bereich des Strahlerzeugers angeordnete zweite Detektor zur Detektion der Elektronen dient, die unter einem relativ geringen Raumwinkel aus dem Objekt austreten und durch die für den Durchtritt des Primärelektronenstrahls vorgesehene Öffnung des ersten Detektors hindurchtreten. Bei dem aus der DE 198 28 476 A1 bekannten Elektronenstrahlgerät ist aber von Nachteil, daß der zweite Detektor stets eine große Anzahl sowohl von Sekundär- als auch von Rückstreuelektronen detektiert. Das mit diesem Detektor erhaltene Signal ist somit ein Mischsignal.

Es ist bekannt, daß zur Erhöhung der Auflösung des Materialkontrastes die Rückstreuelektronen detektiert werden müssen. Um einen besonders guten Materialkontrast zu erhalten, ist es notwendig, möglichst viele Rückstreuelektronen zu erfassen. Denn die Anzahl der detektierten Elektronen verbessert die Bildgebung. Die Abhängigkeit der Bildgebung von der Anzahl der detektierten Elektronen gilt nicht nur für Rückstreuelektronen, sondern auch für Sekundärelektronen. Je höher die Anzahl der detektieren Sekundärelektronen ist, um so besser ist die Bildgebung. Vorteilhaft ist eine Detektion von Elektronen, selektiert nach Sekundär- und Rückstreuelektronen, um so eine nach Elektronenart selektierte Bilderzeugung durchführen zu können.

Aus der US 2002/0185599 A1 ist ein Rasterelektronenmikroskop bekannt, mit dem Sekundärelektronen und Rückstreuelektronen separat erfaßt werden. Hierzu sind in dem Rasterelektronenmikroskop, das einen Strahlerzeuger zur Erzeugung eines Elektronenstrahls und eine Objektivlinse zur Fokussierung des Elektronenstrahls auf dem Objekt aufweist, zwei Detektoren vorgesehen. Ein Detektor ist dabei im Bereich des Objektes angeordnet und dient zur Detektion der Rückstreuelektronen. Der weitere Detektor ist oberhalb der Objektivlinse angeordnet und dient zur Detektion von Sekundärelektronen. Die Position des Detektors zur Detektion der Rückstreuelektronen muß hier jedoch durch Simulationsrechnungen bestimmt werden, was äußerst aufwendig ist. Hinzu kommt, daß Simulationsrechnungen stets mit Fehlern behaftet sind, so daß eine optimale Detektion von Elektronen nicht erreicht werden kann.

Aus der WO 99/46797 ist ein Elektronenstrahlgerät mit einem Strahlerzeuger und einer Objektivlinse zur Fokussierung eines Elektronenstrahls auf einem Objekt bekannt. Ferner ist ein Detektor zur Detektion von vom Objekt emittierten Elektronen bekannt. Ferner sind aus dieser Druckschrift Elektroden in Form von Druckstufenblenden bekannt, wobei eine von ihnen höhenverstellbar ist.

Ferner wird auf die JP 09 167591 A, die JP 2000-188077 A sowie die US 5,097,126 A als Stand der Technik verwiesen.

Der Erfindung liegt die Aufgabe zugrunde, ein Elektronenstrahlgerät mit einer Detektoranordnung anzugeben, mit der eine Selektion insbesondere nach Rückstreu- und Sekundärelektronen auf einfache Weise möglich ist.

Gleichzeitig sollen mittels der Detektoranordnung möglichst viele Elektronen detektiert werden.

Diese Aufgabe wird mit einem Elektronenstrahlgerät mit den Merkmalen des Anspruchs 1 gelöst. Ein erfindungsgemäßes Verfahren ist durch die Merkmale des Anspruchs 17 wiedergegeben. Vorteilhafte Ausgestaltungen ergeben sich aus den Merkmalen der Unteransprüche.

Erfindungsgemäß ist das Elektronenstrahlgerät, insbesondere ein Rasterelektronenmikroskop, mit einem Strahlerzeuger zur Erzeugung eines Elektronenstrahls (nachfolgend auch Primärelektronenstrahl genannt), einer Objektivlinse zur Fokussierung des Primärelektronenstrahls auf einem Objekt und mit mindestens einem Detektor zur Detektion von am Objekt gestreuten oder vom Objekt emittierten Elektronen ausgebildet. Dabei wird nachfolgend unter dem Begriff "gestreute Elektronen" insbesondere vom Objekt zurückgestreute Elektronen verstanden. Ferner weist das Elektronenstrahlgerät mindestens eine einstellbare Blende auf, die dem Detektor zugeordnet ist. Unter einer einstellbaren Blende wird eine hinsichtlich ihrer Position im Elektronenstrahlgerät einstellbare Blende bzw. eine hinsichtlich ihrer Position im Elektronenstrahlgerät einstellbare Blende, deren Blendenöffnung einstellbar ist, verstanden. Dies wird weiter unten nochmals erläutert.

Das erfindungsgemäße Elektronenstrahlgerät geht von der Überlegung aus, daß aufgrund ihrer oben genannten unterschiedlichen Energie Sekundär- und Rückstreuelektronen jeweils einen unterschiedlichen Phasenraum einnehmen. Dieser ist als Orts-Impuls-Raum definiert, wobei der Impuls die Divergenz der Sekundär- bzw. Rückstreuelektronen beschreibt. Aufgrund der unterschiedlichen Phasenräume ist es möglich, einen großen Teil der Sekundärelektronen im Sekundärstrahl auszublenden. Durch die Blende treten dann zum größten Teil nur noch Rückstreuelektronen, die dann vom Detektor detektiert werden können. Es hat sich herausgestellt, daß die Anzahl der auf diese Weise detektierten Rückstreuelektronen gegenüber den aus dem Stand der Technik bekannten Vorrichtungen deutlich höher liegt. Aufgrund der Ausblendung eines großen Teils der Sekundärelektronen beeinflussen diese nicht mehr wesentlich das Signal, das mit dem Detektor zur Bilderzeugung erstellt wird.

Ferner ist es möglich, die Blende immer an die Position im Elektronenstrahlgerät zu bringen, an der eine hohe Anzahl von Rückstreuelektronen detektiert werden kann. Die bevorzugte Position der Blende liegt im oder in der Nähe des Cross-Overs des Strahls des Rückstreuelektronen, die eine gewünschte Energie aufweisen. Zur Einstellung der Position der Blende weist das Elektronenstrahlgerät vorzugsweise mindestens eine Verstelleinrichtung auf, die beispielsweise manuell oder motorisch steuerbar ist. Mittels der Verstelleinrichtung ist es möglich, die Blende in jegliche Richtung zu verstellen, beispielsweise entlang der optischen Achse bzw. des Strahlengangs des Sekundärstrahls. Von Vorteil ist auch, daß man mittels der Verstelleinrichtung die Blende auch aus dem Strahlengang des Sekundärstrahls führen oder in den Strahlengang einführen kann.

Wie oben bereits erwähnt, weist die Blende mindestens eine Blendenöffnung zum Durchlaß der Elektronen auf. Vorzugsweise ist die Größe dieser Blendenöffnung einstellbar. Dies stellt eine weitere Möglichkeit zur Verfügung, eine möglichst hohe Ausbeute an Rückstreuelektronen zu erzielen.

Das erfindungsgemäße Elektronenstrahlgerät ist insbesondere als Rasterelektronenmikroskop ausgebildet. Bei dieser Ausführungsform sind selbstverständlich Rastermittel zur Führung des Primärelektronenstrahls auf dem Objekt vorgesehen. Vorzugsweise weisen die Rastermittel zwei Rasterelemente pro Ebene auf.

Vorzugsweise handelt es sich bei der Blende um eine mechanische Blende mit mindestens einer Blendenöffnung zum Durchlaß der Rückstreuelektronen auf den Detektor. Bei einer besonderen Ausführungsform können mehrere Blendenöffnungen an der Blende vorgesehen sein.

Um Rückstreuelektronen zu detektieren, die mit einem kleinen Winkel vom Objekt gestreut werden (nachfolgend auch Kleinwinkelrückstreuelektronen genannt), sind die Blende und der Detektor vorzugsweise außeraxial zu einer optischen Achse des Elektronenstrahlgerätes angeordnet. Unter der optischen Achse wird dabei diejenige Achse verstanden, auf der die Elektronen des Primärelektronenstrahls vom Strahlerzeuger zum Objekt geführt werden, ohne daß der Primärelektronenstrahl von Ablenkeinheiten aus der optischen Achse geführt wird.

Bei einer besonderen Ausgestaltung des Elektronenstrahlgerätes weist das Elektronenstrahlgerät mindestens eine Ablenkeinrichtung mit mindestens einer Ablenkeinheit zum Aus- bzw. Einführen des Primärelektronenstrahls auf die optische Achse auf. Diese Ausführungsform eignet sich besonders gut, wenn die Blende und der Detektor außeraxial zur optischen Achse des Elektronenstrahlgerätes angeordnet sind. Mittels der Ablenkeinrichtung wird der Primärelektronenstrahl vom Sekundärstrahl (Sekundärelektronen und Rückstreuelektronen) getrennt.

Es ist insbesondere vorgesehen, die Ablenkeinheit der Ablenkeinrichtung als magnetische Einheit auszubilden. Vorzugsweise ist die Ablenkeinheit im Elektronenstrahlgerät im Bereich zwischen dem Objekt und dem Strahlerzeuger angeordnet. Bei einer besonderen Ausführungsform weist die Ablenkeinrichtung eine erste Ablenkeinheit zum Ausführen des Primärelektronenstrahls aus der optischen Achse und eine zweite Ablenkeinheit zum Einführen des Primärelektronenstrahls in die optische Achse auf. Als besonders geeignet hat sich eine Anordnung gezeigt, bei der die Ablenkeinrichtung eine erste Ablenkeinheit zum Ausführen des Elektronenstrahls aus der optischen Achse, eine zweite Ablenkeinheit zum Lenken des Elektronenstrahls in Richtung der optischen Achse und eine dritte Ablenkeinheit zum Einführen des Elektronenstrahls in die optische Achse aufweist. Durch die vogenannten Anordnung(en) bleibt der normale Aufbau eines Rasterelektronenmikroskops, bei dem der Strahlerzeuger und das Objekt im wesentlichen in einer geraden Linie (nämlich der optischen Achse) übereinander angeordnet sind, erhalten.

Der Detektor ist vorzusgweise segmentiert ausgebildet. Dies bedeutet, daß er mindestens zwei Detektionsbereiche umfaßt, wobei ein Detektionsbereich vorgesehen ist, um achsnah zur optischen Achse rücklaufende Elektronen des Sekundärstrahls zu detetkieren. Der weitere Detektionsbereich ist vorgesehen, rücklaufende Elektronen zu detektieren, die nicht achsnah zur optischen Achse im Elektronenstrahlgerät zurücklaufen.

Bei einer weiteren Ausführungsform des erfindungsgemäßen Elektronenstrahlgerätes ist zusätzlich zu dem bereits beschriebenen Detektor ein weiterer Detektor im Elektronenstrahlgerät angeordnet. Wie weiter unten noch näher beschrieben, weist mindestens einer der beiden Detektoren eine Blende auf.

Alternativ hierzu kann der nun hinzugekommene, weitere Detektor vorzugsweise als die oben beschriebene Blende ausgebildet sein und dient dazu, Sekundärelektronen zu detektieren.

In der Regel weist der der Blende zugeordnete Detektor ebenfalls eine Durchlaßöffnung für den Primärelektronenstrahl auf, da der Detektor meist entlang der optischen Achse des Elektronenstrahlgerätes im Elektronenstrahlgerät angeordnet ist. Bei Experimenten wurde festgestellt, daß auch durch diese Durchlaßöffnung ein Teil der Rückstreuelektronen hindurchtritt, ohne vom Detektor detektiert zu werden. Um die Detektion der Rückstreuelektronen bzw. Elektronen zu verbessern, die nahezu entlang der optischen Achse verlaufen, sieht eine besondere Ausführungsform der Erfindung vor, daß ein Reflektor zur Reflexion der von dem Objekt gestreuten oder vom Objekt emittierten Elektronen am Detektor angeordnet ist. Bei einem Beispiel ist die Blende selbst als Reflektor ausgebildet, wobei nur bestimmte Elektronen auf den Detektor reflektiert werden, während weitere Elektronen aus dem Sekundärstrahl ausgeblendet werden. Auf diese Weise wird eine große Anzahl von Rückstreuelektronen, die ansonsten verloren geht, detektiert. Beim Auftreffen der Rückstreuelektronen werden diese am Reflektor gestreut und treffen dann auf eine aktive Detektionsfläche des Detektors.

Der Reflektor ist vorzugsweise in der Öffnung des Detektors aufgenommen. Für den Fall, daß der Detektor als Kombination eines Szintillators mit einem Lichtleiter und einem Photomultiplier ausgebildet ist, ist in das Loch meist ein metallisches Rohr eingesetzt, das den isolierenden Szintillator gegen den Primärelektronenstrahl abschirmt. In diesem Fall ist vorzugsweise vorgesehen, daß der Reflektor in dem metallischen Rohr aufgenommen ist.

Die Blende kann zahlreiche Formen einnehmen, die insbesondere je nach Bauplatz im Elektronenstrahlgerät gewählt wird. Vorzugsweise ist jedoch vorgesehen, daß die Blende, insbesondere die als Reflektor ausgebildete Blende, eine Grundfläche aufweist, an der Seitenflächen angeordnet sind, die sich in Richtung eines über der Grundfläche angeordneten Punktes erstrecken. Hierunter fallen beispielsweise eine dreieckige oder auch eine zumindest teilweise kegelförmige Form. Alternativ oder zusätzlich hierzu ist vorgesehen, daß die Blende zumindest teilweise scheibenförmig ausgebildet ist.

Um eine möglichst große Anzahl von Elektronen zu absorbieren, ist die Blende vorzugsweise aus einem Material mit kleiner Ordnungszahl gefertigt. Ist hingegen vorgesehen, eine möglichst große Anzahl von Elektronen zu reflektieren, ist die Blende aus einem Material mit hoher Ordnungszahl gefertigt.

Bei einem Beispiel ist es vorgesehen, die Blende als Vorrichtung mit mindestens einem Gegenfeldgitter auszubilden. Mittels einer geeigneten angelegten Spannung können Elektronen, insbesondere Sekundär- und Rückstreuelektronen, selektiert werden. Beispielsweise sind mindestens zwei Detektoren vorgesehen, von denen mindestens einer ein derartiges Gegenfeldgitter aufweist. Beispielsweise sind beide Detektoren mit einem Gegenfeldgitter versehen.

Bei einer weiteren Ausführungsform der Erfindung ist eine Elektronenenergiesteuervorrichtung zum Beschleunigen und Abbremsen von Elektronen des Elektronenstrahls auf vorgegebene Energien sowie zum Aufrechterhalten der Energie nach dem Beschleunigen vorgesehen. Die Anmelderin verwendet in von ihr vertriebenen Elektronenstrahlgeräten einen sogenannten "Beambooster", der sicherstellt, daß eine hohe Energie der Elektronen des Primärelektronenstrahls entlang des vollständigen Weges durch eine Elektronenstrahlsäule erhalten bleibt. Erst nach Passieren der Rastermittel und der Fokussiereinheit werden die Elektronen auf eine gewünschte Energie abgebremst.

Ein Ausführungsbeispiel betrifft ferner eine Detektoranordnung zur Detektion von Elektronen, insbesondere für ein Elektronenstrahlgerät, mit mindestens einem Detektor, an dem ein Reflektor zur Reflexion von Elektronen auf den Detektor angeordnet ist. In der Regel weist der Detektor eine Durchlaßöffnung für den Primärelektronenstrahl auf, da der Detektor meist in einem Elektronenstrahlgerät entlang der optischen Achse des Elektronenstrahlgerätes angeordnet ist. Bei Experimenten wurde festgestellt, daß auch durch diese Durchlaßöffnung ein großer Teil von Elektronen des Sekundärstrahls hindurchtritt, ohne vom Detektor detektiert zu werden. Um auch diese Elektronen zu detektieren, ist vorgesehen, den Reflektor an dem Detektor anzuordnen, der die Elektronen auf den Detektor reflektiert und so die Effizienz erhöht.

Der Reflektor kann auf die bereits beschriebene Art am Detektor angeordnet sein und die oben erwähnte Form aufweisen. Ferner ist dem Detektor eine Blende zugeordnet, wie sie bereits oben beschrieben wurde.

Nachfolgend werden Ausführungsbeispiele der Erfindung anhand von Figuren näher erläutert. Es zeigen:
- Fig. 1: eine schematische Darstellung der Phasenräume von Sekundärund Rückstreuelektronen in einem Rasterelektronenmikroskop;
- Fig. 2: eine schematische Darstellung eines Rasterelektronenmikroskops mit einem Detektor und einer Blende;
- Fig. 3: eine schematische Darstellung eines weiteren Rasterelektronenmikroskops mit einem Detektor und einer Blende;
- Fig. 4: eine schematische Darstellung eines Rasterelektronenmikroskops mit einem als Konversionselektrode ausgebildeten Detektor und einer Blende;
- Fig. 5: eine schematische Darstellung eines Rasterelektronenmikroskops mit einem Detektor, der einen Reflektor aufweist;
- Fig. 6: eine schematische Darstellung einer weiteren Ausführungsform eines Detektors mit einem Reflektor;
- Fig. 7: eine schematische Darstellung einer Ablenkeinrichtung, die in einem Rasterelektronenmikroskop angeordnet ist;
- Fig. 8: eine schematische Darstellung eines Rasterelektronenmikroskops mit einem Detektor, dem eine Blende in Form eines Gegenfeldgitters zugeordnet ist;
- Fig. 9: eine schematische Darstellung eines Detektors mit einer Blende nach Fig. 8;
- Fig. 10: eine schematische Darstellung eines Rasterelektronenmikroskops mit zwei Detektoren, denen Blenden in Form von Gegenfeldgittern zugeordnet sind, sowie einem Rasterelement; und
- Fig. 11: eine schematische Darstellung eines Rasterelektronenmikroskops mit zwei Detektoren, denen Blenden in Form von Gegenfeldgittern zugeordnet sind, sowie zwei Rasterelementen.

Die Erfindung wird nachfolgend beispielhaft anhand eines Rasterelektronenmikroskops beschrieben. Sie ist aber nicht auf Rasterelektronenmikroskope eingeschränkt, sondern eignet sich für jedes Elektronenstrahlgerät.

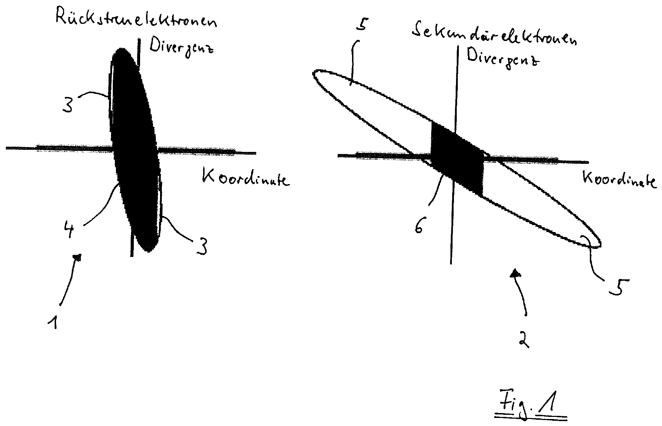

Figur 1 zeigt die unterschiedlichen Phasenräume, die Sekundär- und Rückstreuelektronen in einem Rasterelektronenmikroskop aufweisen. Dieses weist eine Elektronenquelle auf, mittels der ein Primärelektronenstrahl erzeugt und auf eine Probe geleitet wird. Beim Auftreffen des Primärelektronenstrahls auf die Probe kommt es zu Wechselwirkungen, bei denen insbesondere Sekundärelektronen und Rückstreuelektronen entstehen. Deren Gesamtheit bildet einen Sekundärstrahl, der wiederum das Rasterelektronenmikroskop durchläuft und mittels eines Detektors oder mehrerer Detektoren detektiert wird. Wie oben bereits erwähnt, weisen die Rückstreuelektronen dabei eine Energie im Bereich von 50 eV bis zur Energie der Elektronen des Primärelektronenstrahls am Objekt auf, während die Sekundärelektronen eine Energie kleiner als 50 eV aufweisen. Aufgrund dieser unterschiedlichen Energien weisen die Sekundär- und die Rückstreuelektronen unterschiedliche Phasenräume auf, die in Fig. 1 dargestellt sind. Der Phasenraum 1 betrifft Rückstreuelektronen, während der Phasenraum 2 den Phasenraum der Sekundärelektronen darstellt. Das Phasenraumvolumen der Sekundärelektronen ist wesentlich anders als das der Rückstreuelektronen.

Mittels einer Blende, deren Position mittels einer Verstelleinrichtung im Rasterelektronenmikroskop eingestellt werden kann, ist es möglich, einen großen Teil der Sekundärelektronen aus dem Sekundärstrahl auszublenden. Mittels der Blende wird nur ein Transmissionsbereich 6 durchgelassen, während der Bereich 5 von der Blende ausgeblendet wird. Die bevorzugte Position der Blende liegt im oder in der Nähe des Cross-Overs des Strahls des Rückstreuelektronen.

Durch die Verstelleinrichtung ist es möglich, die Blende in jegliche Richtung zu verstellen, beispielsweise entlang der optischen Achse bzw. des Strahlengangs des Sekundärstrahls. Von Vorteil ist auch, daß man mittels der Verstelleinrichtung die Blende auch aus dem Strahlengang des Sekundärstrahls führen oder in den Strahlengang einführen kann. Die Blende wird dort positioniert, an der die Ausbeute der Rückstreuelektronen der gewünschten Energie sehr gut ist.

Die Verwendung einer Blende blendet möglicherweise auch einen gewissen Bereich 3 der Rückstreuelektronen aus. Allerdings überwiegt der Teil der Rückstreuelektronen (Transmissionsbereich 4), der die Blende passieren kann. Mittels der Blende ist es daher möglich, aus dem Sekundärstrahl Rückstreu- und Sekundärelektronen zu selektieren bzw. einen großen Anteil der Sekundärelektronen von den Rückstreuelektronen zu separieren. Die Anzahl der Rückstreuelektronen, die die Blende durchtreten, ist wesentlich höher als die Anzahl der Sekundärelektronen.

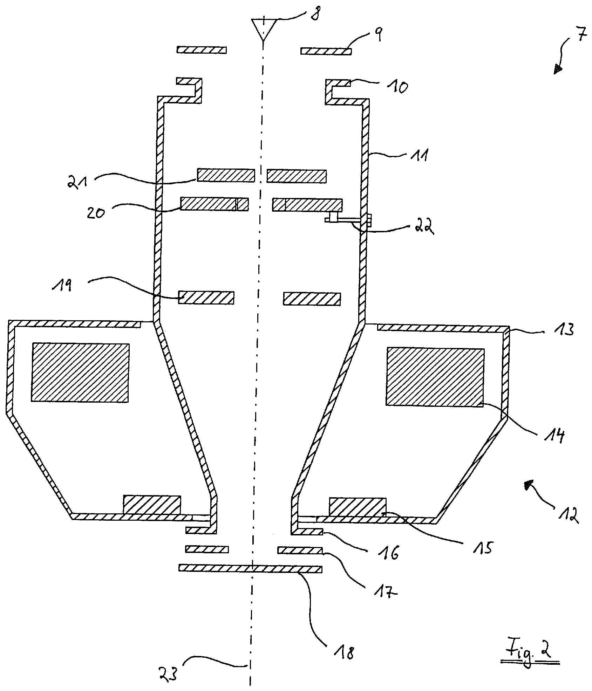

Fig. 2 zeigt die schematische Darstellung eines Rasterelektronenmikroskops 7. Das Rasterelektronenmikroskop 7 weist einen Strahlerzeuger in Form einer Elektronenquelle 8 (Kathode), eine Extraktionselektrode 9 sowie eine Anode 10 auf, die gleichzeitig ein Ende eines Strahlführungsrohres 11 des Rasterelektronenmikroskops 7 bildet. Vorzugsweise ist die Elektronenquelle 8 ein thermischer Feldemitter. Elektronen, die aus der Elektronenquelle 8 austreten, werden aufgrund einer Potentialdifferenz zwischen der Elektronenquelle 8 und der Anode 10 auf Anodenpotential beschleunigt. Im Strahlführungsrohr 11 wird die Energie der Elektronen aufrechterhalten und erst kurz vor Auftreffen auf die Probe auf eine gewünschte Energie abgebremst, was weiter unten noch näher erläutert wird. Eine Vorrichtung mit den vorbeschriebenen Wirkungen wird von der Anmelderin in entsprechende Rasterelektronenmikroskope eingebaut und als "Beambooster" bezeichnet.

Das Strahlführungsrohr 11 ist durch eine Bohrung durch Polschuhe 13 einer als Objektiv wirkenden Magnetlinse geführt. In den Polschuhen 13 sind Spulen 14 angeordnet, wie sie bereits seit langem bekannt sind. Hinter das Strahlführungsrohr 11 ist eine elektrostatische Verzögerungseinrichtung geschaltet. Diese besteht aus einer Einzelelektrode 17 und einer Rohrelektrode 16, die an dem einer Probe 18 gegenüberliegenden Ende des Strahlführungsrohres 11 ausgebildet ist. Somit liegt die Rohrelektrode 16 gemeinsam mit dem Strahlführungsrohr 11 auf Anodenpotential, während die Einzelelektrode 17 sowie die Probe 18 auf einem gegenüber dem Anodenpotential niedrigeren Potential liegen. Auf diese Weise können die Elektronen des Primärelektronenstrahls auf eine gewünschte niedrige Energie abgebremst werden, die für die Untersuchung der Probe 18 erforderlich ist. Ferner sind Rastermittel 15 vorgesehen, durch die der Primärelektronenstrahl abgelenkt und über die Probe 18 gerastert werden kann.

Zur Detektion von Sekundärelektronen oder Rückstreuelektronen, die aufgrund der Wechselwirkung des Primärelektronenstrahls mit der Probe 18 entstehen, ist eine Detektoranordnung im Strahlführungsrohr 11 angeordnet, die einen Detektor 19 und einen Detektor 21 aufweist. Der Detektor 19 ist dabei probenseitig entlang der optischen Achse (23) im Strahlführungsrohr 11 angeordnet, während der Detektor 21 entlang der optischen Achse 23 quellenseitig angeordnet ist. Ferner sind die beiden Detektoren 19, 21 in Richtung der optischen Achse 23 des Rasterelektronenmikroskops 7 versetzt zueinander angeordnet und weisen jeweils eine ringförmige Detektionsfläche auf.

Der Detektor 19 ist dabei in bekannter Weise als Szintillator mit einem Glaslichtleiter und einem dahintergeschalteten Photomultiplier ausgebildet. Der Glaslichtleiter leitet in bekannter Weise Photonen zum Photomultiplier. Da der Glaslichtleiter für eine hohe Effizienz der Lichtleitung eine relativ große Dicke in Richtung der optischen Achse 23 aufweist, weist die Bohrung durch den Glaslichtleiter für den Durchtritt des Primärelektronenstrahls einen Durchmesser in der Regel von 2 bis 3 mm auf, damit der Primärelektronenstrahl durch den Glaslichtleiter nicht beeinflußt wird.

Der Detektor 19 dient zur Detektion derjenigen Elektronen, die unter einem relativ großen Raumwinkel aus der Probe 18 austreten. Dabei handelt es sich in erster Linie um Sekundärelektronen. An der Probe 18 zurückgestreute Elektronen (Rückstreuelektronen), die im Vergleich zu den Sekundärelektronen eine relativ hohe kinetische Energie beim Austritt aus der Probe 18 aufweisen, werden dagegen vom Detektor 19 nur zu einem sehr geringen Anteil erfaßt, da die Rückstreuelektronen, die die Beschleunigungsrichtung passieren, relativ nah zur optischen Achse 23 von der Linse fokussiert werden und somit durch das Loch des Detektors 19 durchtreten können.

Nach Durchlaufen des Detektors 19 umfaßt der Sekundärstrahl somit sowohl Sekundärelektronen als auch Rückstreuelektronen, wobei allerdings schon ein großer Teil der aus der Probe 18 emittierten Sekundärelektronen nicht mehr im Sekundärstrahl vorhanden ist.

Dem Detektor 21 ist eine Blende 20 zugeordnet, die sich mittels einer Verstelleinrichtung 22 in alle Richtungen im Strahlführungsrohr 11 bewegen läßt. Die Blende 20 ist geeigneterweise aus einem Material mit hoher Ordnungszahl gefertigt, beispielsweise Gold. Beim Auftreffen des Sekundärstrahls auf die Unterseite der Blende 20 werden Sekundärelektronen aufgrund ihrer Energieverteilung aus dem Sekundärstrahl ausgeblendet. Durch das Loch der Blende 20 transmittieren demnach hauptsächlich nur noch Rückstreuelektronen, die dann mittels des Detektors 21 detektiert werden können.

Der Detektor 21 ist dabei segmentiert und weist zwei Detektionsbereiche 38 und 39 auf, deren Funktion oben bereits erläutert wurde. Die detektierten Rückstreuelektronen werden bei der Bildgebung hinsichtlich der Erhöhung des Materialkontrastes verwendet. Die Verstelleinrichtung 22 dient dabei zur optimalen Einstellung der Position der Blende 20, um eine möglichst große Anzahl an Rückstreuelektronen der gewünschten Energie zu detektieren. Die Größe der Öffnung der Blende 20 ist mittels einer nicht dargestellten Vorrichtung einstellbar.

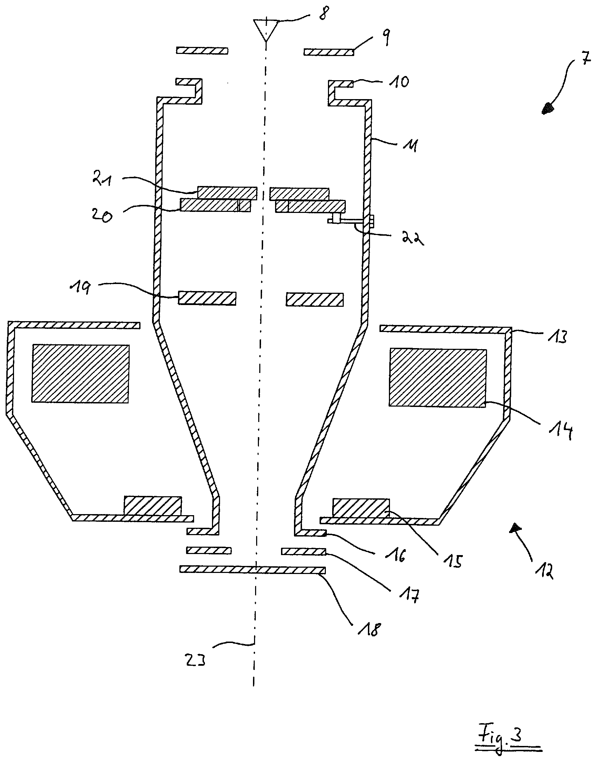

Fig. 3 zeigt ein weiteres Ausführungsbeispiel eines Rasterelektronenmikroskops 7. Dieses Ausführungsbeispiel ist zu dem Ausführungsbeispiel gemäß Fig. 2 fast identisch. Nachfolgend werden daher die identischen Bauteile mit den gleichen Bezugszeichen beschrieben. Das Ausführungsbeispiel gemäß Fig. 3 unterscheidet sich vom Ausführungsbeispiel gemäß Fig. 2 nur dahingehend, daß die Blende 20 auf dem Detektor 21 angeordnet ist. Dies soll verdeutlichen, daß mittels der Verstelleinrichtung 22 die Blende an jede beliebige Position im Rasterelektronenmikroskop gebracht werden kann.

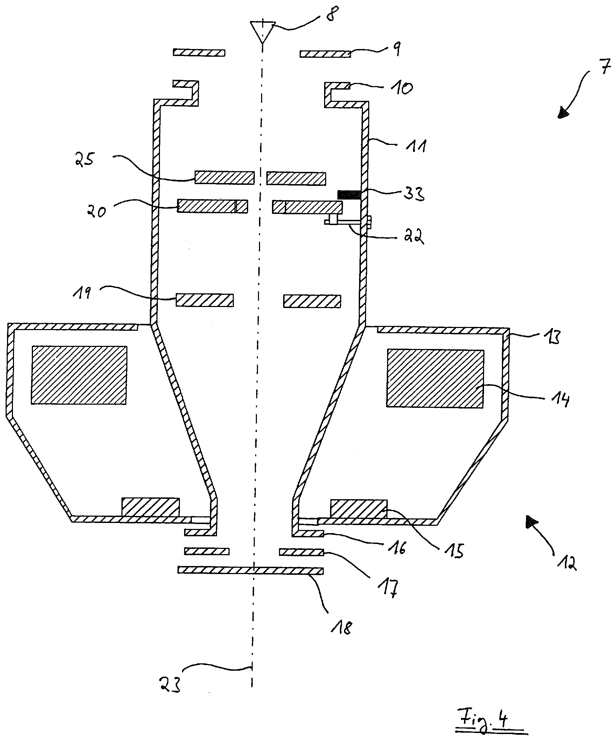

Fig. 4 zeigt ein weiteres Ausführungsbeispiel eines Rasterelektronenmikroskops 7. Identische Bauteile sind wiederum mit den gleichen Bezugszeichen gekennzeichnet. Das Ausführungsbeispiel gemäß Fig. 4 weist wiederum eine Detektoranordnung mit zwei Detektoren auf, nämlich den Detektoren 19 und 25. Der Detektor 19 ist probenseitig angeordnet, während der Detektor 25 quellenseitig angeordnet ist. Dem Detektor 25 ist wiederum die Blende 20 in der schon oben beschriebenen Weise zugeordnet. Im Unterschied zu den bisher beschriebenen Ausführungsbeispielen ist der Detektor 25 als ringförmige Konversionselektrode ausgebildet. Die Konversionselektrode ist mittels einer nicht dargestellten Justiereinrichtung in beiden Richtungen senkrecht zur optischen Achse justierbar. Der Detektor 25 ist als eine dünne Platte mit einer Dicke von 0,1 bis 1 mm aus einem Material mit kleiner Ordnungszahl (beispielsweise Aluminium) ausgebildet und weist ein kleines zentrales Loch für den Durchtritt des Primärelektronenstrahls auf. Der Lochdurchmesser beträgt in der Regel 200 µm bis 400 µm. Aufgrund des geringen Lochdurchmessers wirkt der Detektor 25 aperturbegrenzend für den Primärelektronenstrahl und wirkt damit gleichzeitig als Aperturblende.

Beim Auftreffen des Sekundärstrahls auf den Detektor 25 werden aus dem Detektor 25 Sekundärelektronen ausgelöst, die zu einem Detektor 33 gesaugt werden und dort im Detektor 33 detektiert werden. Die Absaugung und die Beschleunigung der Sekundärelektronen vom Detektor 25 zum Detektor 33 sind seit langem bekannt und werden hier nicht weiter beschrieben.

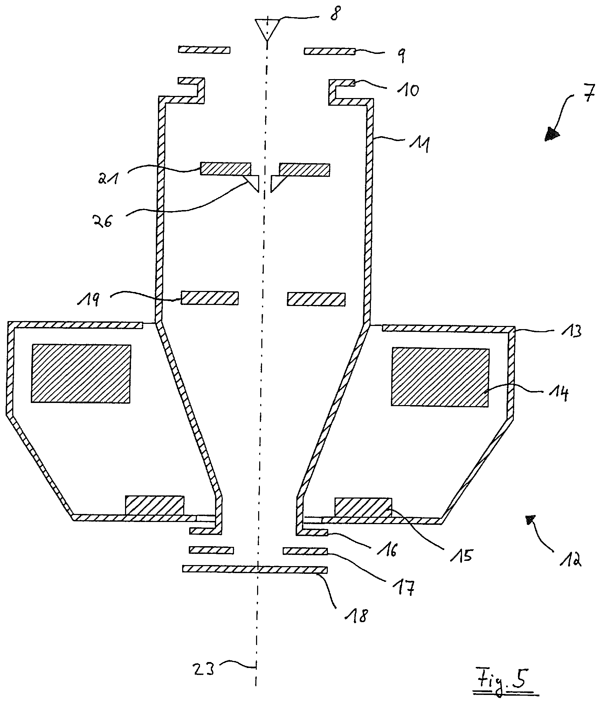

Fig. 5 zeigt ein Beispiel eines Rasterelektronenmikroskops 7 mit einer Detektoranordnung, die zwei Detektoren 19 und 21 aufweist. Wie oben bereits beschrieben, detektiert der Detektor 19 fast ausschließlich Sekundärelektronen. Die Anordnung des Detektors 19 an der optischen Achse 23 ist dabei derart gewählt, daß im wesentlichen nur noch Rückstreuelektronen den Detektor 19 passieren. Da der Detektor 21 ebenfalls eine Öffnung aufweist, können einige Rückstreuelektronen durch diese Öffnung treten. Sie werden dann nicht detektiert und gehen für die Bilderzeugung verloren.

Aus diesem Grund ist an dem Detektor 21 eine kegelförmige Blende 26 in Form eines Reflektors angeordnet, der vorteilhaft aus einem Material mit hoher Ordnungszahl gebildet ist (beispielsweise Gold). Die durch den Detektor 19 tretenden Elektronen werden an dem Reflektor gestreut und in Richtung der Detektionsfläche des Detektors 19 gelenkt.

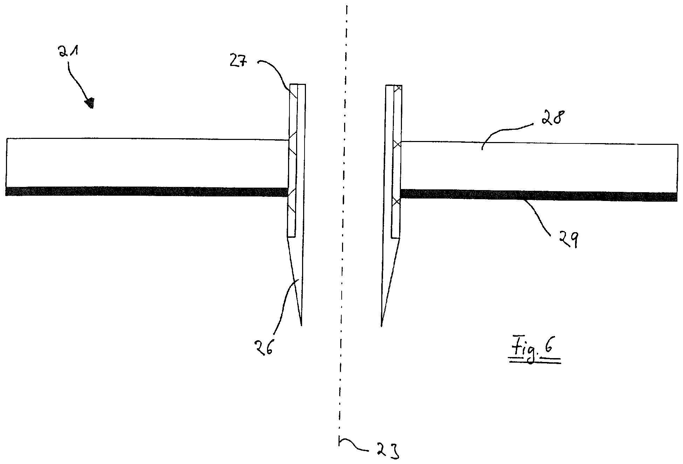

Die Funktionsweise des Reflektors wird anhand eines Beispiels des Detektors 21 gemäß Fig. 6 nochmals verdeutlicht. Fig. 6 zeigt den Detektor 21, der einen Szintillator 29 als Detektionsfläche aufweist, an dem sich ein Lichtleiter 28 anschließt. Dem Lichtleiter 28 nachgeschaltet ist ein Photomultiplier (nicht dargestellt), der seitlich des Detektors 21 angeordnet ist. Der Detektor 21 weist, wie oben bereits beschrieben, eine Öffnung auf. In der Öffnung ist metallisches Rohr 27 eingesetzt, durch das der Primärelektronenstrahl den Detektor 21 passieren kann. Der Innendurchmesser des Rohres 27 beträgt in der Regel 2 mm. Dieser Durchmesser ist notwendig, um den isolierenden Szintillator 28 gegen den Primärelektronenstrahl abzuschirmen und erlaubt es, das Rohr so groß auszubilden, um es vernünftig polieren zu können, so daß es oxidfrei gehalten werden kann.

In das Rohr 27 ist der kegelförmig ausgebildete Reflektor 26 eingesetzt. Beim Auftreffen von Rückstreuelektronen auf den Reflektor 26 werden diese am Reflektor 26 gestreut bzw. auf den Detektor bzw. dessen Szintillator 29 reflektiert. Die Elektronenausbeute (Detektoreffizienz) ist um so größer, je steiler die kegelförmige Ausbildung des Reflektors 26 und je größer die Ordnungszahl des Materials ist, aus dem der Reflektor 26 gefertigt ist.

Die in Fig. 6 beschriebene Anordnung (auch ohne das Rohr 27) eignet sich nicht nur zur Detektion von Rückstreuelektronen. Vielmehr können auch Sekundärelektronen mit einem derartigen Detektor detektiert werden. Beispielsweise kann der Detektor 19 derart ausgebildet sein. Die beschriebene Anordnung des Reflektors 26 ist geeignet, die Elektronenausbeute jedweder Elektronen bei einem Detektor zu erhöhen.

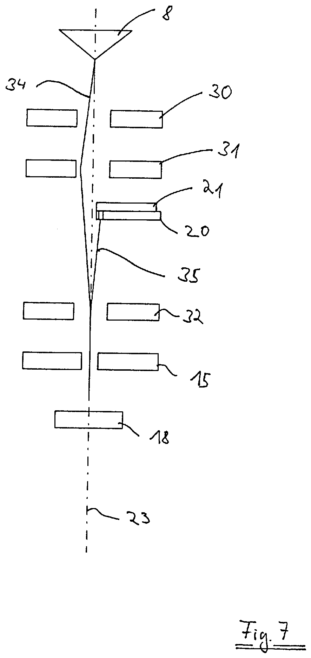

Um auch Rückstreuelektronen zu detektieren, die unter einem sehr kleinen Winkel hinsichtlich der optischen Achse 23 an der Probe 18 gestreut werden, sieht das Ausführungsbeispiel gemäß Fig. 7 vor, den Detektor 21 und die ihm zugeordnete Lochblende 20 außeraxial der optischen Achse 23 anzuordnen. Hierzu weist das Rasterelektronenmikroskop eine Ablenkeinrichtung mit Ablenkeinheiten 30, 31 und 32 auf. Sämtliche Ablenkeinheiten sind entlang der optischen Achse 23 angeordnet und sind als magnetische Einheiten ausgebildet. Der von der Elektronenquelle 8 erzeugte Primärelektronenstrahl 34 wird mittels der Ablenkeinheit 30 aus der optischen Achse 23 ausgelenkt. Durch die Ablenkeinheit 31 wird der Primärelektronenstrahl 34 wiederum auf die optische Achse 23 geführt und nimmt anschließend den Weg, den er ohne die Ablenkeinheiten einnehmen würde. Mittels der Rastermittel 15 wird der Primärelektronenstrahl 34 dann über die Probe 18 gerastert.

Die aufgrund der Wechselwirkung entstehenden Sekundär- und Rückstreuelektronen treten dann wieder in das Strahlführungsrohr des Rasterelektronenmikroskops als Sekundärstrahl 35 ein. Sowohl Sekundärelektronen als auch Rückstreuelektronen werden aufgrund der Ablenkeinheit 32 gemäß dem Lorentz-Kraftgesetz in den zum Halbraum des Primärelektronenstrahls 34 komplementären Halbraum abgelenkt, in dem sich der Detektor 21 befindet. Durch die Blende 20 werden die Sekundärelektronen ausgeblendet, so daß der Detektor 21 fast ausschließlich nur noch Rückstreuelektronen detektiert.

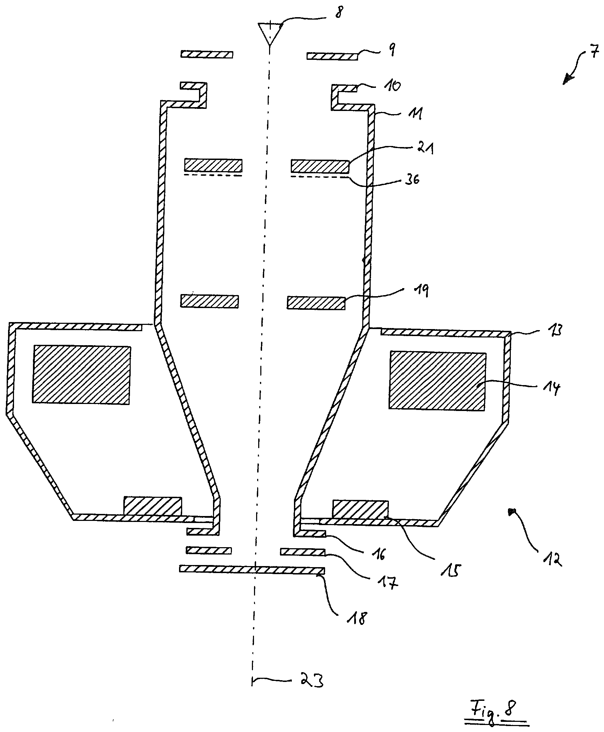

Fig. 8 zeigt ein Beispiel eines Rasterelektronenmikroskops. Dieses Beispiel ist zu dem Ausführungsbeispiel gemäß Fig. 2 fast identisch. Nachfolgend werden daher identische Bauteile mit den gleichen Bezugszeichen beschrieben. Der Detektor 21 weist ein Gegenfeldgitter 36 auf. Die aufgrund der Wechselwirkung mit der Probe 18 entstehenden Sekundär- und Rückstreuelektronen werden wieder in das Strahlführungsrohr 11 des Rasterelektronenmikroskops eingeführt. Die an dem Gegenfeldgitter 36 angelegte Spannung ist derart gewählt, daß Sekundärelektronen vom Gegenfeldgitter 36 abgelenkt werden können, so daß sie nicht auf den Detektor 21 treffen. In diesem Fall treten nur noch Rückstreuelektronen durch das Gegenfeldgitter 36 und treffen auf den Detektor 21. Die entsprechenden Signale werden dann zur Bilderzeugung verwendet. Beispielsweise weist das Gegenfeldgitter 36 eine Spannung von - 100 Volt auf. Die Rückstreuelektronen können aufgrund ihrer Energien durch das Gitter hindurchtreten. Die Sekundärelektronen, die in der Regel eine Energie < 50 eV aufweisen, können aufgrund der angelegten Spannungen nicht zum Detektor 21 gelangen.

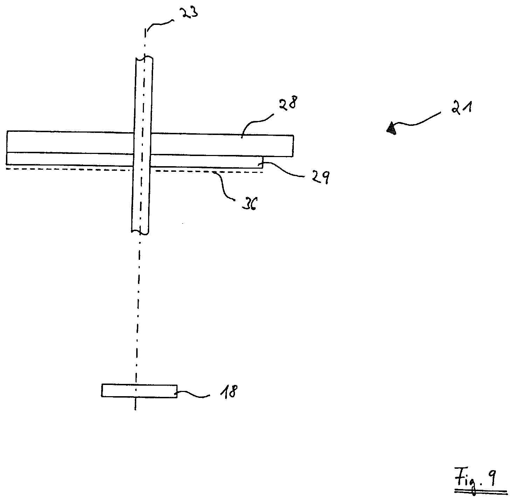

Eine besondere Ausführungsform des Detektors 21, wie sie in dem Beispiel gemäß Fig. 8 verwendet werden kann, ist in Fig. 9 dargestellt. Der Detektor 21 ist scheibenförmig ausgebildet und weist einen Szintillator 29 auf, über dem ein Lichtleiter 28 angeordnet ist. Der Lichtleiter 28 ist wiederum mit einem Photomultiplier (nicht dargestellt) verbunden. Der Detektor 21 weist eine Öffnung auf, in der ein Metallrohr aufgenommen ist, in dem der Primärelektronenstrahl entlang der optischen Achse 23 verläuft. Die aufgrund der Wechselwirkung mit der Probe 18 entstehenden Sekundär- und Rückstreuelektronen werden wieder in das Strahlführungsrohr des Rasterelektronenmikroskops eingeführt. Vor dem Szintillator 29 ist das Gegenfeldgitter 36 angeordnet. Die an dem Gegenfeldgitter 36 angelegte Spannung ist derart gewählt, daß Sekundärelektronen vom Gegenfeldgitter 36 abgelenkt werden können, so daß sie nicht auf den Szintillator 29 treffen. In diesem Fall treten nur noch Rückstreuelektronen durch das Gegenfeldgitter 36 und treffen auf den Szintillator 29. Die entsprechenden Signale werden dann zur Bilderzeugung verwendet.

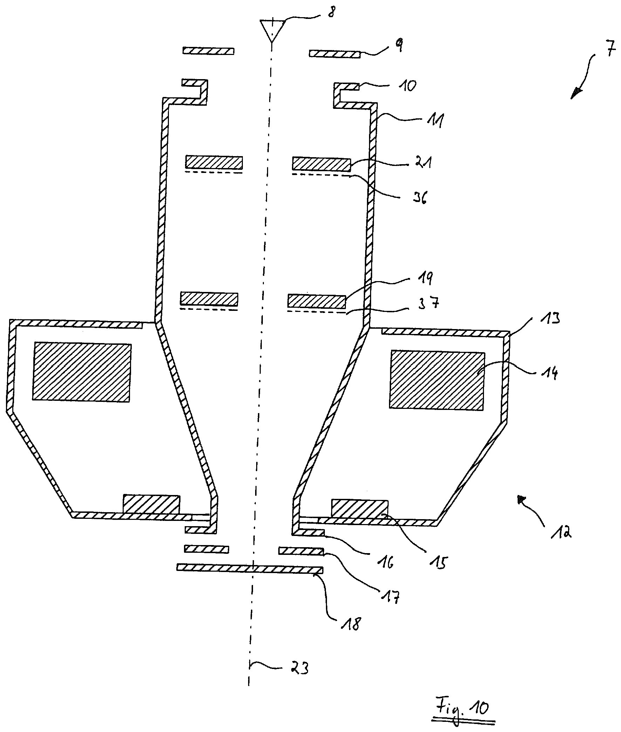

Ein weiteres Beispiel des Rasterelektronenmikroskops ist in Fig. 10 dargestellt. Dieses Beispiel entspricht im Grunde dem Beispiel gemäß Fig. 8. Im Unterschied hierzu sind bei dem Beispiel gemäß Fig. 10 der Detektor 21 mit einem Gegenfeldgitter 36 und der Detektor 19 mit einem Gegenfeldgitter 37 versehen.

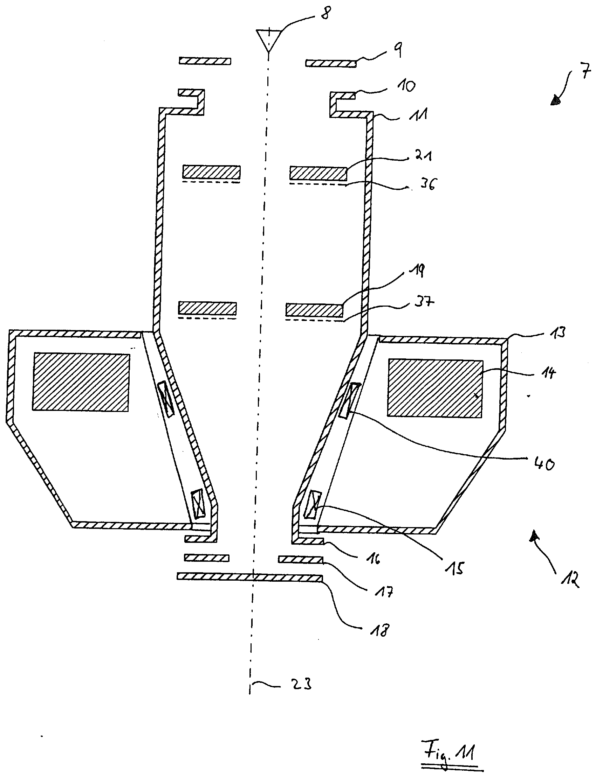

Ein ähnliches Beispiel des Rasterelektronenmikroskops ist in Fig. 11 gezeigt. Auch hier weisen die beiden Detektoren 19 und 21 Gegenfeldgitter 36 und 37 auf. Ferner sind zwei Rasterelemente 15 und 40 zur Rasterung des Primärelektronenstrahls über die Probe 28 vorgesehen. Es hat sich nämlich gezeigt, daß sich Rückstreuelektronen mit einem Streuwinkel von ≥ 165° bei höheren Energien des Primärelektronenstrahls nicht zur Hochauflösungsabbildung eignen, was auf die erhöhte Mehrfachstreuung der Rückstreuelektronen zurückzuführen ist. Allerdings werden aufgrund der Geometrie der Objektivlinse sowie des Strahlführungsrohres nur Rückstreuelektronen mit einem Streuwinkel von ≥ 165° erfaßt. Mittels zweier Rasterelemente 15, 40 (Doppelrasterelement) wird die lichte Weite des Strahlführungsrohres vergrößert, so daß auch unter 150° gestreute Rückstreuelektronen detektiert werden können. Diese weisen eine geringe Wahrscheinlichkeit zur Doppelstreuung auf und führen demnach zu schärferen Bildern. Ferner wird eine Steigerung der Transmission von Elektronen erzielt.

### Bezugszeichenliste

- 1: Phasenraum Rückstreuelektronen
- 2: Phasenraum Sekundärelektronen
- 3: ausgeblendeter Bereich
- 4: Transmissionsbereich
- 5: ausgeblendeter Bereich
- 6: Transmissionsbereich
- 7: Rasterelektronenmikroskop
- 8: Elektronenquelle
- 9: Extraktionselektrode
- 10: Anode
- 11: Strahlführungsrohr
- 12: Objektivlinse
- 13: Polschuh der als Objektiv wirkenden Linse
- 14: Spule einer Magnetlinse
- 15: Rastermittel
- 16: Rohrelektrode
- 17: Elektrode
- 18: Probe
- 19: Detektor
- 20: Blende
- 21: Detektor
- 22: Verstelleinrichtung
- 23: optische Achse
- 24: Detektor
- 25: Konversionselektrode
- 26: Reflektor
- 27: Metallrohr
- 28: Lichtleiter
- 29: Szintillator
- 30: Ablenkeinheit
- 31: Ablenkeinheit
- 32: Ablenkeinheit
- 33: Detektor
- 34: Primärelektronenstrahl
- 35: Sekundärstrahl
- 36: Gitter
- 37: Gitter
- 38: Segment
- 39: Segment
- 40: Rasterelement

## Patentansprüche

1. Elektronenstrahlgerät, insbesondere ein Rasterelektronenmikroskop, mit
- einem Strahlerzeuger (8) zur Erzeugung eines Elektronenstrahls (34),
- einer Objektivlinse (12) zur Fokussierung des Elektronenstrahls (34) auf einem Objekt (18),
- mindestens einem Detektor (21) zur Detektion von am Objekt (18) zurückgestreuten oder vom Objekt (18) emittierten Elektronen (35),
wobei
- das Elektronenstrahlgerät mindestens eine einstellbare Blende (20) aufweist,
- die Position der Blende (20) im Elektronenstrahlgerät einstellbar ist, und wobei
- die Blende (20) mindestens eine Blendenöffnung zum Durchlass der am Objekt (18) zurückgestreuten Elektronen auf den Detektor (21) aufweist,
**dadurch gekennzeichnet, dass**
- die Blende (20) dem Detektor (21) zugeordnet ist, und dass
- die Blende (20) derart eingerichtet ist, dass ein großer Teil der vom Objekt emittierten Elektronen ausgeblendet wird, so dass durch die Blende (20) zum größten Teil am Objekt zurückgestreute Elektronen treten, die dann vom Detektor (21) detektiert werden.

2. Elektronenstrahlgerät nach Anspruch 1, wobei das Elektronenstrahlgerät
- eine optische Achse (23) und
- einen weiteren Detektor (19) zur Detektion von vom Objekt (18) emittierten Elektronen aufweist,
wobei der weitere Detektor (19) objektseitig entlang der optischen Achse (23) angeordnet ist, und wobei der Detektor (21) quellenseitig entlang der optischen Achse (23) angeordnet ist.

3. Elektronenstrahlgerät nach Anspruch 1, wobei die Blende (20) objektseitig des Detektors (21) angeordnet ist.

4. Elektronenstrahlgerät nach Anspruch 2, wobei die Blende (20) objektseitig des quellenseitig angeordneten Detektors (21) angeordnet ist.

5. Elektronenstrahlgerät nach einem der vorangehenden Ansprüche, wobei die Blende (20) im Cross-Over eines Strahls der am Objekt zurückgestreuten Elektronen liegt.

6. Elektronenstrahlgerät nach einem der vorangehenden Ansprüche, wobei eine Verstelleinrichtung (22) zur Verstellung der Position der Blende (20) im Elektronenstrahlgerät angeordnet ist.

7. Elektronenstrahlgerät nach einem der vorangehenden Ansprüche, wobei die Größe der Blendenöffnung einstellbar ist.

8. Elektronenstrahlgerät nach einem der vorangehenden Ansprüche, wobei Rastermittel (15,40) zur Führung des Elektronenstrahls (34) auf das Objekt (18) vorgesehen sind.

9. Elektronenstrahlgerät nach Anspruch 8, wobei die Rastermittel mindestens zwei Rasterelemente (15, 40) pro Ebene aufweisen.

10. Elektronenstrahlgerät nach einem der vorangehenden Ansprüche aber stets nicht in Verbindung mit Anspruch 2, wobei das Elektronenstrahlgerät eine optische Achse (23) aufweist und wobei die Blende (20) und der Detektor (21) außeraxial zur optischen Achse (23) angeordnet sind.

11. Elektronenstrahlgerät nach einem der vorangehenden Ansprüche, wobei mindestens eine Ablenkeinrichtung (30, 31, 32) mit mindestens einer Ablenkeinheit zum Aus- bzw. Einführen des Elektronenstrahls (34) auf die optische Achse vorgesehen ist.

12. Elektronenstrahlgerät nach Anspruch 11, wobei die Ablenkeinheit (30, 31, 32) im Elektronenstrahlgerät im Bereich zwischen dem Objekt (18) und dem Strahlerzeuger (8) angeordnet ist.

13. Elektronenstrahlgerät nach Anspruch 11 oder 12, wobei die Ablenkeinrichtung eine erste Ablenkeinheit (30) zum Ausführen des Elektronenstrahls (34) aus der optischen Achse (23) und eine zweite Ablenkeinheit (31, 32) zum Einführen des Elektronenstrahls (34) in die optische Achse (23) aufweist.

14. Elektronenstrahlgerät nach Anspruch 11 oder 12, wobei die Ablenkeinrichtung eine erste Ablenkeinheit (30) zum Ausführen des Elektronenstrahls (34) aus der optischen Achse (23), eine zweite Ablenkeinheit (31) zum Lenken des Elektronstrahls (34) in Richtung der optischen Achse (23) und eine dritte Ablenkeinheit (32) zum Einführen des Elektronenstrahls (34) in die optische Achse (23) aufweist.

15. Elektronenstrahlgerät nach einem der vorangehenden Ansprüche aber stets nicht in Verbindung mit Anspruch 2, wobei das Elektronenstrahlgerät zusätzlich zu dem Detektor (21) nach Anspruch 1 noch einen weiteren Detektor (19) aufweist.

16. Elektronenstrahlgerät nach einem der vorangehenden Ansprüche, wobei eine Elektronen-Energiesteuervorrichtung zum Beschleunigen und Abbremsen von Elektronen des Elektronenstrahls auf vorgegebene Energien sowie zum Aufrechterhalten der Energie nach dem Beschleunigen vorgesehen ist.

17. Verfahren zum Betrieb eines Elektronenstrahlgeräts, umfassend folgende Schritte:
- Bereitstellen eines Strahlerzeugers (8) zur Erzeugung eines Elektronenstrahls (34),
- Bereitstellen einer Objektivlinse (12) zur Fokussierung des Elektronenstrahls auf einem Objekt (18),
- Bereitstellen von mindestens einem Detektor (21) zur Detektion von am Objekt (18) zurückgestreuten oder vom Objekt (18) emittierten Elektronen (35),
- Bereitstellen von mindestens einer einstellbaren Blende (20), wobei die Position der Blende (20) im Elektronenstrahlgerät einstellbar ist,
**gekennzeichnet durch**
- das Bereitstellen der Blende (20) derart, dass die Blende (20) dem Detektor (21) zugeordnet ist, und **durch**
- Positionieren der Blende (20) derart, dass ein großer Teil der vom Objekt emittierten Elektronen ausgeblendet wird, so dass **durch** die Blende (20) zum größten Teil zurückgestreute Elektronen treten, die dann vom Detektor (21) detektiert werden.

## Claims

1. Electron beam machine, in particular a scanning electron microscope, comprising
- a beam generator (8) for generating an electron beam (34),
- an objective lens (12) for focusing the electron beam (34) onto an object (18),
- at least one detector (21) for detecting electrons (35) scattered back at the object (18) or emitted by the object (18),
wherein
- the electron beam machine comprises at least one adjustable stop (20),
- the position of the stop (20) in the electron beam machine is adjustable, and wherein
- the stop (20) comprises at least one aperture for passing electrons which are scattered back at the object (18) onto the detector (21),
**characterized in that**
- the stop (20) is assigned to the detector (21) and **in that**
- the stop (20) is configured such that a large portion of the electrons emitted by the object are masked, and so mainly electrons scattered back at the object pass through the stop (20) and are subsequently detected by the detector (21).

2. Electron beam machine according to Claim 1, wherein the electron beam machine comprises
- an optical axis (23) and
- a further detector (19) for detecting electrons emitted by the object (18),
wherein the further detector (19) is arranged along the optical axis (23) on the object side and wherein the detector (21) is arranged along the optical axis (23) on the source side.

3. Electron beam machine according to Claim 1, wherein the stop (20) is arranged on the object side of the detector (21).

4. Electron beam machine according to Claim 2, wherein the stop (20) is arranged on the object side of the detector (21) arranged on the source side.

5. Electron beam machine according to one of the preceding claims, wherein the stop (20) lies in the crossover of a beam of electrons scattered back at the object.

6. Electron beam machine according to one of the preceding claims, wherein an adjustment device (22) for adjusting the position of the stop (20) is arranged in the electron beam machine.

7. Electron beam machine according to one of the preceding claims, wherein the dimension of the aperture is adjustable.

8. Electron beam machine according to one of the preceding claims, wherein provision is made of scanning means (15, 40) for guiding the electron beam (34) onto the object (18).

9. Electron beam machine according to Claim 8, wherein the scanning means have at least two scanning elements (15, 40) per plane.

10. Electron beam machine according to one of the preceding claims, but never in conjunction with Claim 2, wherein the electron beam machine comprises an optical axis (23) and wherein the stop (20) and the detector (21) are arranged off axis in relation to the optical axis (23).

11. Electron beam machine according to one of the preceding claims, wherein provision is made of at least one deflection device (30, 31, 32) comprising at least one deflection unit for guiding the electron beam (34) onto, or from, the optical axis.

12. Electron beam machine according to Claim 11, wherein the deflection unit (30, 31, 32) is arranged in the electron beam machine in the region between the object (18) and the beam generator (8).

13. Electron beam machine according to Claim 11 or 12, wherein the deflection machine comprises a first deflection unit (30) for guiding the electron beam (34) from the optical axis (23) and a second deflection unit (31, 32) for guiding the electron beam (34) onto the optical axis (23).

14. Electron beam machine according to Claim 11 or 12, wherein the deflection unit comprises a first deflection unit (30) for guiding the electron beam (34) from the optical axis (23), a second deflection unit (31) for directing the electron beam (34) in the direction of the optical axis (23) and a third deflection unit (32) for guiding the electron beam (34) onto the optical axis (23).

15. Electron beam machine according to one of the preceding claims, but never in conjunction with Claim 2, wherein the electron beam machine comprises a further detector (19) in addition to the detector (21) according to Claim 1.

16. Electron beam machine according to one of the preceding claims, wherein provision is made of an electron energy control apparatus for accelerating and decelerating electrons of the electron beam to predetermined energies and for maintaining the energy after acceleration.

17. Method for operating an electron beam machine, comprising the following steps:
- providing a beam generator (8) for generating a electron beam (34),
- providing an objective lens (12) for focusing the electron beam onto an object (18),
- providing at least one detector (21) for detecting electrons (35) scattered back at the object (18) or emitted by the object (18),
- providing at least one adjustable stop (20), wherein the position of the stop (20) in the electron beam machine is adjustable,
**characterized by**
- the provision of the stop (20) such that the stop (20) is assigned to the detector (21) and by
- positioning the stop (20) such that a large portion of the electrons emitted by the object are masked, and so mainly electrons scattered back pass through the stop (20) and are subsequently detected by the detector (21).

## Revendications

1. Appareil à faisceaux d'électrons, en particulier un microscope électronique à balayage, avec :
- un générateur de faisceaux (8) destiné à la génération d'un faisceau d'électrons (34) ;
- une lentille de focalisation (12) destinée à la focalisation du faisceau d'électrons (34) sur un objet (18) ;
- au moins un détecteur (21) destiné à la détection des électrons (35) émis par l'objet (18) ou réfléchis sur l' obj et (18),
où
- l'appareil à faisceaux d'électrons présente au moins un diaphragme (20) réglable,
- la position du diaphragme (20) est réglable dans l'appareil à faisceaux d'électrons, et où
- le diaphragme (20) présente au moins une ouverture de diaphragme destiné au passage sur le détecteur (21) des électrons réfléchis sur l'objet (18),
**caractérisé en ce que**
- le diaphragme (20) est associé au détecteur (21) ; et **en ce que**
- le diaphragme (20) est configuré de telle sorte qu'une grande partie des électrons émis par l'objet est masquée, de telle sorte que des électrons réfléchis sur l'objet pénètrent en grande partie à travers le diaphragme (20), lesquels électrons sont alors détectés par le détecteur (21).

2. Appareil à faisceaux d'électrons selon la revendication 1, où l'appareil à faisceaux d'électrons présente :
- un axe optique (23) et
- un autre détecteur (19) en vue de la détection des électrons émis par l'objet (18),
où l'autre détecteur (19) est disposé le long de l'axe optique (23), du côté où se trouve l'objet, et où le détecteur (21) est disposé le long de l'axe optique (23), du côté où se trouve la source.

3. Appareil à faisceaux d'électrons selon la revendication 1, où le diaphragme (20) est disposé du côté où se trouve l'objet du détecteur (21).

4. Appareil à faisceaux d'électrons selon la revendication 2, où le diaphragme (20) est disposé du côté où se trouve l'objet du détecteur (21) qui est disposé du côté où se trouve la source.

5. Appareil à faisceaux d'électrons selon l'une des revendications précédentes, où le diaphragme (20) repose dans le cross-over d'un faisceau des électrons réfléchis sur l'objet.

6. Appareil à faisceaux d'électrons selon l'une des revendications précédentes, où un mécanisme de réglage (22) destiné à l'ajustement de la position du diaphragme (20) est disposé dans l'appareil à faisceaux d'électrons.

7. Appareil à faisceaux d'électrons selon l'une des revendications précédentes, où la taille de l'ouverture de diaphragme est réglable.

8. Appareil à faisceaux d'électrons selon l'une des revendications précédentes, où des moyens servant de balayage (15, 40) sont prévus en vue du guidage du faisceau d'électrons (34) sur l'objet (18).

9. Appareil à faisceaux d'électrons selon la revendication 8, où les moyens servant de balayage présentent au moins deux éléments de balayage (15, 40) par plan.

10. Appareil à faisceaux d'électrons selon l'une des revendications précédentes, mais qui n'est pas constamment en relation avec la revendication 2, où l'appareil à faisceaux d'électrons présente un axe optique (23) et où le diaphragme (20) et le détecteur (21) sont disposés de manière désaxée par rapport à l'axe optique (23).

11. Appareil à faisceaux d'électrons selon l'une des revendications précédentes, où est prévu au moins un mécanisme déflecteur (30, 31, 32) avec au moins une unité de déflexion en vue de la sortie du faisceau d'électrons (34) en dehors de l'axe optique, respectivement en vue de l'introduction du faisceau d'électrons sur l'axe optique.

12. Appareil à faisceaux d'électrons selon la revendication 11, où l'unité de déflexion (30, 31, 32) est disposée dans l'appareil à faisceaux d'électrons, dans la zone se trouvant entre l'objet (18) et le générateur de faisceaux (8).

13. Appareil à faisceaux d'électrons selon la revendication 11 ou 12, où le mécanisme déflecteur présente une première unité de déflexion (30) destinée à la sortie du faisceau d'électrons (34) en dehors de l'axe optique (23), ainsi qu'une deuxième unité de déflexion (31, 32) destinée à l'introduction du faisceau d'électrons (34) dans l'axe optique (23).

14. Appareil à faisceaux d'électrons selon la revendication 11 ou 12, où le mécanisme déflecteur présente une première unité de déflexion (30) destinée à la sortie du faisceau d'électrons (34) en dehors de l'axe optique (23), une deuxième unité de déflexion (31) destinée à orienter le faisceau d'électrons (34) dans la direction de l'axe optique (23), ainsi qu'une troisième unité de déflexion (32) destinée à l'introduction du faisceau d'électrons (34) dans l'axe optique (23).

15. Appareil à faisceaux d'électrons selon l'une des revendications précédentes, mais qui n'est pas constamment en relation avec la revendication 2, où l'appareil à faisceaux d'électrons présente encore un autre détecteur (19), en plus du détecteur (21) selon la revendication 1.

16. Appareil à faisceaux d'électrons selon l'une des revendications précédentes, où est prévu un dispositif de commande énergétique des électrons destiné à l'accélération et à la décélération des électrons du faisceau d'électrons sur des énergies prédéterminées, ainsi qu'en vue de la conservation de l'énergie après l'accélération.

17. Procédé destiné au fonctionnement d'un appareil à faisceaux d'électrons, comprenant les phases suivantes :
- mise en oeuvre d'un générateur de faisceaux (8) en vue de la génération d'un faisceau d'électrons (34) ;
- mise en oeuvre d'une lentille de focalisation (12) en vue de la focalisation du faisceau d'électrons sur un objet (18) ;
- mise en oeuvre d'au moins un détecteur (21) en vue de la détection des électrons (35) émis par l'objet (18) ou réfléchis sur l'objet (18) ;
- mise en oeuvre d'au moins un diaphragme (20) réglable, où la position du diaphragme (20) est réglable dans l'appareil à faisceaux d'électrons,
**caractérisé par**
- la mise en oeuvre du diaphragme (20), de telle sorte que le diaphragme (20) est associé au détecteur (21) ; et **caractérisé par**
- le positionnement du diaphragme (20), de telle sorte qu'une grande partie des électrons émis par l'objet est masquée, de telle sorte que des électrons réfléchis pénètrent en grande partie à travers le diaphragme (20), lesquels électrons sont alors détectés par le détecteur (21).
